# EUROPEAN PATENT SPECIFICATION

(11) **EP 3 444 309 B1**
(45) Date of publication and mention of the grant of the patent: **16.07.2025**
(21) Application number: 18189581.4
(22) Date of filing: 17.08.2018
(51) Int. Cl.: C09G 1/02, H01L 21/304, H01L 21/321

(54) **CHEMICAL MECHANICAL PLANARIZATION (CMP) COMPOSITION AND METHODS THEREFORE FOR COPPER AND THROUGH SILICA VIA (TSV) APPLICATIONS**
ZUSAMMENSETZUNG ZUM CHEMISCH-MECHANISCHEN PLANARISIEREN (CMP) UND VERFAHREN DAFÜR FÜR KUPFER- UND SILICIUMDIOXIDDURCHKONTAKTIERUNGSANWENDUNGEN
COMPOSITION DE PLANARISATION MÉCANIQUE ET CHIMIQUE (CMP) ET PROCÉDÉS CORRESPONDANTS POUR LE CUIVRE ET À TRAVERS LA SILICE VIA DES APPLICATIONS (TSV)

(30) Priority: 17.08.2017 US 201762546914 P; 13.08.2018 US 201816101869
(43) Date of publication of application: 20.02.2019
(73) Proprietor: Versum Materials US, LLC, Tempe, AZ 85284 (US)
(72) Inventor: SHI, Xiaobo, Tempe, Arizona 85284 (US); MATZ, Laura, M, Tempe, Arizona 85284 (US); LI, Chris, Keh-Yeuan, Tempe, Arizona 85284 (US); TSAI, Ming-Shih, Tempe, Arizona 85284 (US); PAN, Pao, Chia, Tempe, Arizona 85284 (US); HSIEH, Chad, Chang-Tse, Tempe, Arizona 85284 (US); YANG, Rung-Je, Tempe, Arizona 85284 (US); LEW, Blake, J, Tempe, Arizona 85284 (US); O'NEILL, Mark, Leonard, Tempe, Arizona 85284 (US); DERECSKEI-KOVACS, Agnes, Tempe, Arizona 85284 (US)
(74) Representative: Beck Greener LLP

(56) References cited:
- EP-A1- 1 775 337
- EP-A1- 2 818 526
- EP-A1- 2 977 418
- EP-A1- 3 088 486
- US-A1- 2009 203 566
- AMLIA SANTOS M ET AL: "Hydroxypyridinones as privileged chelating structures for the design of medicinal drugs", COORDINATION CHEMISTRY REVIEWS, ELSEVIER SCIENCE, AMSTERDAM, NL, vol. 256, no. 1, 8 August 2011 (2011-08-08), pages 240 - 259, XP028124075, ISSN: 0010-8545, [retrieved on 20110816], DOI: 10.1016/J.CCR.2011.08.008

## Description

### BACKGROUND OF THE INVENTION

This invention relates generally to the chemical-mechanical planarization or chemical-mechanical polishing (CMP) of semiconductor wafers. More specifically, the present invention relates to high and tunable removal rates and low dishing formulations for broad or advanced node copper or Through Silica Via (TSV) CMP applications. CMP polishing formulations, CMP polishing compositions or CMP polishing slurries are interchangeable in present invention.

Copper is the current material of choice for the interconnect metal used in the fabrication of integrated electronic devices due to its low resistivity, high reliability, and scalability. Copper chemical mechanical planarization (Cu CMP) processes are necessary to remove copper overburden from inlaid trench structures while achieving global planarization with low metal loss.

With advancing technology nodes, the need to reduce metal dishing and metal loss is becoming increasingly important. Any new polishing formulations must also maintain high removal rates, high selectivity to the barrier material and low defectivity.

Copper CMP is known from the prior art, for example, in US9,305,806; US20160314989; US20130092651; US 20130078811; US 8,679,980; US 8,791,019; US 8,435,421; US 7,955,520; US 20130280910; US 20100221918; US 8,236,695; TW I385226; US 20120094490; US 7,955,520; US US20040175942, US6773476, and US8236695.

However, the formulations disclosed in the prior art are unable to meet the performance requirements of high removal rates and low dishing which become more and more challenging for advanced technology nodes.

This invention discloses bulk copper CMP polishing formulations developed to meet challenging requirements of low dishing and high removal rates for advanced technology nodes.

### BRIEF DESCRIPTION OF THE DRAWINGS

Figure 1 shows Cu polishing results of formulations with single, dual and tris chelators;
Figure 2 shows Cu dishing results of formulations with single, and tris chelators;
Figure 3 shows Cu dishing results of formulations with tris chelators with and without choline bicarbonate;
Figure 4 shows Cu defect count results of formulations with single, dual and tris chelators (0.2µm).

### BRIEF SUMMARY OF THE INVENTION

Described herein are CMP polishing compositions, methods and systems for copper or Through Silica Via (TSV) CMP applications.

In a first aspect, the present invention provides a copper chemical mechanical polishing (CMP) composition, such as a copper bulk CMP or Through Silica Via (TSV) composition, comprising:
a) 0.0025 wt.% to 25 wt.% abrasive;
b) 0.1 wt. % to 18.0 wt. % tris chelators;
c) 0.005 wt.% to 0.5 wt.% corrosion inhibitor;
d) 0.0005 wt.% to 0.25 wt.% organic quaternary ammonium salt;
e) 0.1 wt.% to 10 wt.% oxidizing agent;
f) 0.0001 wt.% to 0.05 wt.% biocide;
g) 0 wt.% to 1 wt.% pH adjusting agent; and
h) water;
wherein
the first tris chelator is an organic amine selected from the group consisting of ethylenediamine, propylenediamine, and butylenediamine; and the second and third chelators are two different amino acids, two different amino acid derivatives, or combinations of one amino acid with one amino acid derivative; and
the pH of the composition is from 3.0 to 12.0; preferably from 5.5 to 7.5; and more preferably from 7.0 to 7.35.

In another aspect, the invention provides a method of chemical mechanical polishing a semiconductor substrate having at least one surface comprising copper or a copper-containing material and at least one second material, using a chemical mechanical polishing composition according to the first aspect comprising steps of:
1. providing the semiconductor substrate;
2. providing a polishing pad;
3. providing the chemical mechanical polishing composition of the first aspect;
4. contacting the at least one surface with the polishing pad and the chemical mechanical polishing composition; and
5. polishing the at least one surface to remove copper or copper-containing material;
   wherein at least a portion of the at least one surface is in contact with both the polishing pad and the chemical mechanical polishing composition.

In yet another aspect, the present invention provides a system for chemical mechanical polishing a semiconductor substrate having at least one surface comprising copper or copper-containing material and at least one second material, the system comprising
1. the semiconductor substrate;
2. a polishing pad;
3. a chemical mechanical polishing composition according to the first aspect;
wherein at least a portion of the at least one surface is in contact with both the polishing pad and the chemical mechanical polishing composition.

The abrasive is selected from the group consisting of colloidal silica or high purity colloidal silica; colloidal silica particles doped with one or more metal oxides within the lattice of the colloidal silica, such as for example alumina doped silica particles; colloidal aluminum oxide; colloidal and photoactive titanium dioxide, cerium oxide, colloidal cerium oxide, nano-sized inorganic metal oxide particles, such as for example alumina, titania, zirconia, ceria etc.; nano-sized diamond particles, nano-sized silicon nitride particles; mono-modal, bi-modal, multi-modal colloidal abrasive particles; organic polymer-based soft abrasives, surface-coated or modified abrasives; composite particles; and combinations thereof. The colloidal aluminum oxide may for example comprise one or more of alpha-, beta- or gamma-types of aluminum oxides.

The organic quaternary ammonium salt is a choline salt, such as a choline bicarbonate salt, or any other salts formed between choline and other anionic counter ions.

The corrosion inhibitor is selected from the group consisting of 1,2,4-triazole, benzotriazole and benzotriazole derivatives, tetrazole and tetrazole derivatives, imidazole and imidazole derivatives, benzimidazole and benzimidazole derivatives, pyrazole and pyrazole derivatives, and combinations thereof.

The biocide includes but is not limited to Kathon^{™} or Kathon^{™} CG/ICP II from Dow Chemical Co. These biocides have active ingredients of 5-chloro-2-methyl-4-isothiazolin-3-one and 2-methyl-4-isothiazolin-3-one.

The oxidizing agent includes, but is not limited to, periodic acid, hydrogen peroxide, potassium iodate, potassium permanganate, ammonium persulfate, ammonium molybdate, ferric nitrate, nitric acid, potassium nitrate, and mixtures thereof.

The amino acids and amino acid derivatives are selected from the group consisting of glycine, D-alanine, L-alanine, DL-alanine, beta-alanine, valine, leucine, isoleuecine, phenylamine, proline, serine, threonine, tyrosine, glutamine, asparanine, glutamic acid, aspartic acid, tryptophan, histidine, arginine, lysine, methionine, cysteine, iminodiacetic acid, and combinations thereof.

### DETAILED DESCRIPTION OF THE INVENTION

As industry standards trend toward smaller device features, there is a continuously developing need for new Cu bulk metal polishing slurries that afford high and tunable Cu removal rates and low Cu dishing for broad and advanced node applications.

The copper bulk CMP or Through Silica Via (TSV) polishing compositions described herein satisfy the need for high and tunable Cu film removal rates, for high selectivity between copper and dielectric films, for high selectivity between copper and barrier films, for low and more uniform Cu line dishing across various wide Cu line features, and for better Cu film corrosion protection through using the suitable corrosion inhibitors.

The Cu CMP polishing compositions of the present invention comprise tris chelators, i.e. three chelating agents, an organic quaternary ammonium salt as an additional Cu dishing and defect reducer, a Cu corrosion inhibitor for efficient Cu corrosion protection, an abrasive such as nano-sized high purity colloidal silica, an oxidizing agent such as hydrogen peroxide, and water as a solvent.

The Cu CMP polishing compositions provide high and tunable Cu removal rates, and low barrier film and dielectric film removal rates which provide very high and desirable selectivity for Cu film vs. other barrier films, such as Ta, TaN, Ti, and TiN, and dielectric films, such as TEOS, low-k, and ultra low-k films, and low Cu dishing and more uniform Cu dishing across wide Cu line features.

The Cu chemical mechanical polishing compositions of the present invention also provide no pad stain Cu CMP performances which allow extended polish pad life and also allow more stable end-point detections.

The abrasive particles used for the Cu bulk CMP polishing compositions of the present invention are selected from the following: colloidal silica or high purity colloidal silica; colloidal silica particles doped with one or more metal oxides within the lattice of the colloidal silica, such as for example alumina doped silica particles; colloidal aluminum oxide; colloidal and photoactive titanium dioxide; cerium oxide, colloidal cerium oxide, nano-sized inorganic metal oxide particles, such as for example alumina, titania, zirconia, ceria etc.; nano-sized diamond particles; nano-sized silicon nitride particles; mono-modal, bi-modal, multi-modal colloidal abrasive particles; organic polymer-based soft abrasives; surface-coated or modified abrasives; composite particles; and mixtures thereof. The colloidal aluminum oxide may comprise one or more of alpha-, beta- or gamma-type aluminum oxides.

The colloidal silica can be made from silicate salts, and the high purity colloidal silica can be made from TEOS or TMOS. The colloidal silica or high purity colloidal silica can have narrow or broad particle size distributions with mono-model or multi-models, various sizes and various shapes including spherical shape, cocoon shape, aggregate shape and other shapes.

The nano-sized particles can also have different shapes, such as spherical, cocoon, aggregate, and others.

The Cu bulk CMP polishing compositions of the present invention comprise 0.0005 wt.% to 25 wt.% abrasive, preferably 0.0025 wt.% to 25 wt.%; preferably from 0.0025 wt.% to 2.5 wt.%, and most preferably from 0.005 wt.% to 0.15 wt.%.

The organic quaternary ammonium salt is a choline salt, such as a choline bicarbonate salt, or any other salts formed between choline and other anionic counter ions.

The choline salts can have the general molecular structure shown below: 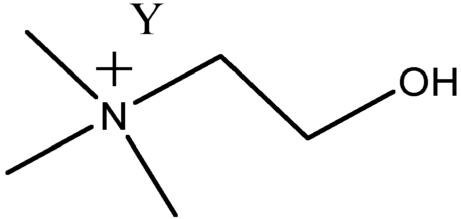 wherein the anion Y⁻ can be a bicarbonate, a hydroxide, a p-toluene-sulfonate, a bitartrate, or any other suitable anionic counter ion.

The CMP slurry of the present invention comprises from 0.0005 wt.% to 0.25 wt.% organic quaternary ammonium salt, preferably from 0.001 wt.% to 0.05 wt.%; and most preferably from 0.002 wt.% to 0.01 wt.%.

Various per-oxy inorganic or organic oxidizing agents or other types of oxidizing agents can be used to oxidize the metallic copper film to the mixture of copper oxides to allow their quick reactions with chelating agents and corrosion inhibitors. The oxidizing agent includes, but is not limited to, periodic acid, hydrogen peroxide, potassium iodate, potassium permanganate, ammonium persulfate, ammonium molybdate, ferric nitrate, nitric acid, potassium nitrate, and mixtures thereof. The preferred oxidizer is hydrogen peroxide.

The CMP slurry of the present invention comprises from 0.1 wt.% to 10 wt.% oxidizing agents; preferably from 0.25 wt.% to 3 wt.%; and most preferably from 0.5 wt.% to 2.0 wt.%.

The corrosion inhibitors used for the copper bulk CMP slurry of the present invention are selected from 1,2,4-triazole, benzotriazole and benzotriazole derivatives, tetrazole and tetrazole derivatives, imidazole and imidazole derivatives, benzimidazole and benzimidazole derivatives, and pyrazole and pyrazole derivatives.

The CMP slurry comprises from 0.005 wt.% to 0.5 wt.% corrosion inhibitor; preferably from 0.01 wt.% to 0.1 wt.%; and most preferably from 0.025 wt.% to 0.05 wt.%.

A biocide having active ingredients for providing more stable shelf time of the invented Cu chemical mechanical polishing compositions can be used.

The biocide includes but is not limited to Kathon^{™} or Kathon^{™} CG/ICP II, from Dow Chemical Co. These biocides have active ingredients of 5-chloro-2-methyl-4-isothiazolin-3-one and 2-methyl-4-isothiazolin-3-one.

The CMP slurry comprises 0.0001 wt.% to 0.05 wt.% biocide; preferably from 0.0002 wt.% to 0.025 wt.%; and most preferably from 0.002 wt.% to 0.01 wt.%.

Optionally, acidic or basic compounds or pH adjusting agents can be used to allow the pH of the Cu bulk CMP polishing compositions to be adjusted to the optimized pH value.

The pH adjusting agents include, but are not limited to the following: nitric acid, hydrochloric acid, sulfuric acid, phosphoric acid, other inorganic or organic acids, and mixtures thereof. The pH adjusting agents also include basic pH adjusting agents such as sodium hydride, potassium hydroxide, ammonium hydroxide, tetraalkyl ammonium hydroxide, organic amines, and other chemical reagents that can be used to adjust the pH towards the more alkaline direction.

The CMP slurry of the present invention comprises from 0 wt.% to 1 wt.% pH adjusting agent; preferably from 0.01 wt.% to 0.5 wt.%; and most preferably from 0.1 wt.% to 0.25 wt.%

The pH of the Cu CMP polishing compositions of the present invention is in the range of from 3.0 to 12.0; preferably in the range of from 5.5 to 7.5; and most preferably in the range of from 7.0 to 7.35.

The CMP slurry of the present invention comprises from 0.1 wt.% to 18 wt.% in total of three chelators or chelating agents (i.e. tris chelators); preferably from 0.5 wt.% to 10 wt.%; and most preferably from 1.0 wt.% to 2.5 wt.%.

The first of the tris chelators is an organic amine selected from the group consisting of ethylenediamine, propylenediamine, and butylenediamine; and the second and third chelators are two different amino acids, two different amino acid derivatives, or combinations of one amino acid with one amino acid derivative. As a specific example, the tris chelators (three chelators) can be glycine, alanine and ethylenediamine.

The three chelators are used as complexing agents to maximize their reactions with the oxidized Cu film surfaces to form softer Cu-chelator layers to be quickly removed during Cu CMP process thus achieving high and tunable Cu removal rates and low copper dishing for broad or advanced node copper or TSV (Through Silica Via) CMP applications.

The amino acids and amino acid derivatives are selected from glycine, D-alanine, L-alanine, DL-alanine, beta-alanine, valine, leucine, isoleuecine, phenylamine, proline, serine, threonine, tyrosine, glutamine, asparanine, glutamic acid, aspartic acid, tryptophan, histidine, arginine, lysine, methionine, cysteine, iminodiacetic acid, and combinations thereof.

The associated methods of the present invention use the aforementioned compositions for chemical mechanical planarization of substrates comprising copper. In the methods of the present invention, a substrate (e.g., a wafer with Cu surface or Cu plug) can be placed face-down on a polishing pad which is fixedly attached to a rotatable platen of a CMP polisher. In this manner, the substrate to be polished and planarized is placed in direct contact with the polishing pad. A wafer carrier system or polishing head can be used to hold the substrate in place and to apply a downward pressure against the backside of the substrate during CMP processing while the platen and the substrate are rotated. The polishing composition (slurry) is applied (usually continuously) on the pad during CMP processing to effect the removal of material to planarize the substrate.

The polishing composition and associated methods of the present invention are effective for CMP of a wide variety of substrates and are particularly use for polishing copper substrates.

### Experimental Section

Polishing Pad Polishing pad, IC1010 pad or Other polishing pad was used during Cu CMP, supplied by Dow Chemicals Company.

### PARAMETERS:

Å: angstrom(s) - a unit of length (1Å = 1 x 10⁻¹⁰ m)
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: polishing composition flow, ml/min

### Removal Rates

Cu RR 1.5 psi Measured Copper removal rate at 1.5 psi (10.2 kPa) down pressure of the CMP tool
Cu RR 2.5 psi Measured Copper removal rate at 2.5 psi (17.2 kPa) down pressure of the CMP tool

### General Experimental Procedure

All percentages are weight percentages unless otherwise indicated. In the examples presented below, CMP experiments were run using the procedures and experimental conditions given below. The CMP tool that was used in the examples was a 300mm LK^{®} polisher, or a Mirra^{®} polisher, manufactured by Applied Materials, 3050 Boweres Avenue, Santa Clara, California, 95054. An IC1010 pad or other type of polishing pad, supplied by Dow Chemicals Company was used on the platen for the blanket wafer polishing studies. Pads were broken-in by polishing twenty-five dummy oxide (deposited by plasma enhanced CVD from a TEOS precursor, PETEOS) wafers. In order to qualify the tool settings and the pad break-in, two PETEOS monitors were polished with Syton^{®} OX-K colloidal silica, supplied by Planarization Platform of Air Products Chemicals Inc. at baseline conditions. Polishing experiments were conducted using blanket Cu wafers with 10.8K Angstroms in thickness, Ta and TEOS blanket wafers. These blanket wafers were purchased from Silicon Valley Microelectronics, 1150 Campbell Ave, CA, 95126.

### Working Example

In the following working examples, the Cu slurry composition with a single chelator (not in accordance with the present invention) comprised 0.713 wt.% of glycine, 0.0323 wt.% of 1,2,4-triazole, 0.00644 wt.% of high purity colloidal silica, and 0.00018 wt.% of biocide. The Cu slurry# 1 composition with dual chelators (two chelators) (not in accordance with the present invention) comprised 0.5 wt.% of glycine, 0.70625 wt.% of alanine, 0.03525 wt.% of 1,2,4-triazole, 0.01042 wt.% of high purity colloidal silica, and 0.00016 wt.% of biocide. The Cu slurry# 2 composition with tris chelators (three chelators) (in accordance with the present invention) comprised 0.5 wt.% of glycine, 0.70625 wt.% of alanine, 0.0012 wt.% of ethylenediamine, 0.00289 wt.% of choline bicarbonate, 0.03525 wt.% of 1,2,4-triazole, 0.01042 wt.% of high purity colloidal silica, and 0.00016 wt.% of biocide.

All three of the above compositions used 1.0 wt.% of H₂O₂ as oxidizing agent at point of use. The CMP polishing compositions had a pH ranging from 7.00 to 7.35.

### Example 1

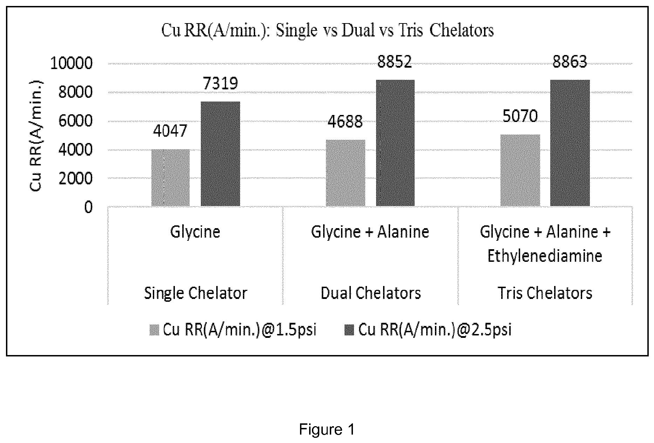

The polishing results from using the Cu bulk CMP polishing compositions are listed in Table 1 and depicted in Figure 1.

The single chelator was glycine, the dual chelators were glycine and alanine (alanine includes DL-Alanine; D-Alanine; and L-Alanine), and the tris chelators were glycine, alanine and ethylenediamine. In the tris chelator based polishing composition, an organic quaternary ammonium salt, choline bicarbonate, was also used.

**Table 1. The Effects of Tris or Dual Chelator Cu Slurries vs. Single Chelator Cu Slurry on Cu Removal Rates**

| Sample | Cu Removal (Å/min.) at 1.5psi (10.2 kPa) DF | Cu Removal Rate (Å/min.) at 2.5psi (17.2 kPa) DF |
|---|---|---|
| Cu Slurry with single chelator, Glycine | 4047 | 7319 |
| Cu Slurry# 1 with dual chelators, Glycine + DL-Alanine | 4688 | 8852 |
| Cu Slurry# 2 with tris chelators, Glycine + DL-Alanine +ethylenediamine + Choline Bicarbonate | 5070 | 8863 |

The Cu CMP polishing compositions described herein afforded high and compatible Cu film removal rates when using tris chelator based Cu CMP polishing compositions.

The dual chelator based Cu slurry provided a 16% higher Cu removal rate at 1.5 psi (10.2 kPa) DF than the single chelator based Cu slurry, and a 21% higher Cu removal rate at 2.5 psi (17.2 kPa) DF than the single chelator based Cu slurry.

The tris chelator based Cu slurry provided a 25% higher Cu removal rate at 1.5 psi (10.2 kPa) DF than the single chelator based Cu slurry, and a 22% higher Cu removal rate at 2.5 psi (17.2 kPa) DF than the single chelator based Cu slurry.

Also, the tris chelator based Cu slurry provided a 8% higher Cu removal rate at a 1.5 psi (10.2 kPa) DF than the dual chelator based Cu slurry.

The 8% increase in the Cu removal rate at 1.5 psi (10.2 kPa) DF mainly resulted from the use of a third chelator, ethylenediamine, which is a binary chelating agent and reacts very effectively with Cu oxides to form water soluble Cu-etheylenediamine complexes and is subsequently removed during the Cu CMP process.

### Example 2

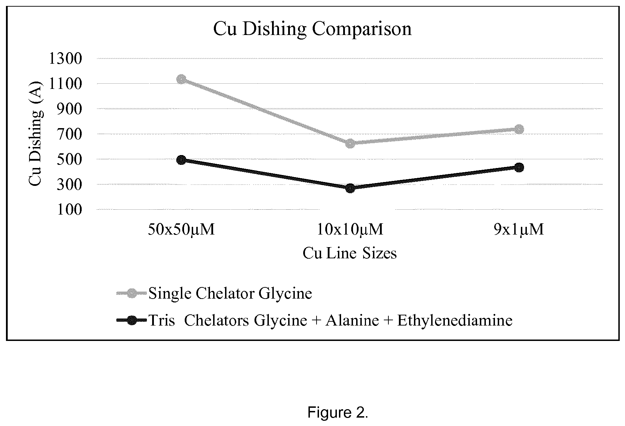

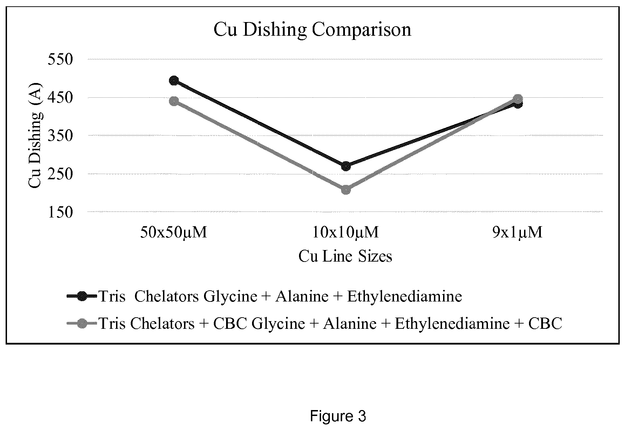

The polishing effects of the tris chelator based Cu CMP polishing compositions with/or without choline bicarbonate as an additional additive, and the single chelator based Cu polishing compositions on wide Cu line feature dishing are shown in Table 2, and depicted in Figure 2 and Figure 3.

**Table 2. Wide Cu Line Dishing: Single Chelator Cu Slurry vs Tris Chelator Cu Slurries**

| Sample | Averaged Cu Dishing (Å) on 50x50µM | Averaged Cu Dishing (Å) on 10x10µM | Averaged Cu Dishing (Å) on 9x1µM |
|---|---|---|---|
| Cu Slurry#1 with single chelator, Glycine | 1135 | 624 | 737 |
| Cu Slurry# 2 with tris chelators, Glycine + DL-Alanine + EDA | 493 | 270 | 434 |
| Cu Slurry# 3 with tris chelators, Glycine + DL-Alanine + EDA + CBC | 441 | 209 | 446 |

| | | | |
|---|---|---|---|
| EDA: Ethylenediamine; CBC: Choline Bicarbonate | | | |

As the wide Cu line dishing data showed in Table 2, the Cu slurry with tris chelators, glycine/alanine/ethylenediamine provided a much lower Cu dishing on wide Cu line features than the Cu slurry only using single chelator, glycine.

On a 50x50µM Cu line feature, the averaged Cu dishing of the tris chelator based Cu slurry was reduced by 56.6% when compared to the Cu slurry only using a single chelator, glycine. On a 10x10µM Cu line feature, the averaged Cu dishing of the tris chelator based Cu slurry was reduced by 56.7% when compared to the Cu slurry only using a single chelator, glycine. And on a 9x1µM Cu line feature, the averaged Cu dishing of the tris chelator based Cu slurry was reduced by 41.1% when compared to the Cu slurry using only a single chelator, glycine.

Further, the use of a choline bicarbonate salt in the tris chelator based Cu slurry also led to Cu line dishing reductions on 50x50µM and 10x10µM features. The Cu line dishing were reduced by about 11% and 23% respectively on the 50x50µM and 10x10µM features with the use of a choline bicarbonate salt in a glycine/alanine/ethylenediamie based tris chelator Cu slurry.

Also, the tris chelator based Cu slurry or the tris chelator based Cu slurry with choline bicarbonate afforded more uniform Cu line dishing across the three wide Cu line features. The delta of the Cu line dishing for the 50x50µM, 10x10µM and 9x1µM Cu line features was 511Å for the Cu slurry using glycine as single chelator, 223 Å for the Cu slurry using glycine/alanine/ethylenediamine as tris chelators, and 232Å for a Cu slurry using glycine/alanine/ethylenediamine as tris chelators plus choline bicarbonate as an additional additive to further reduce the Cu line dishing on some sized Cu line features.

### Example 3

The tris chelator based Cu slurry or tris chelator based Cu slurry with choline bicarbonate salt also reduced the Cu defect counts significantly compared to the single chelator based Cu slurry. The 0.2micron Cu defect count results at 1.5psi (10.2 kPa) DF are listed in Table 3.

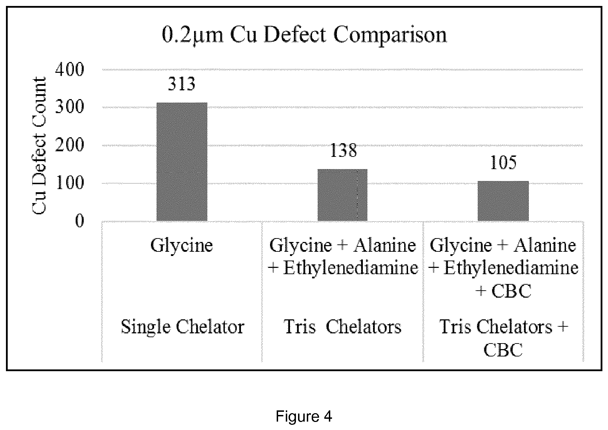

As the Cu defect count data shows in Table 3 and depicted in Figure 4, the Cu defect count was reduced by 56% for the glycine/alanine/ethylenediamine based tris chelator Cu slurry when compared to the glycine based single chelator Cu slurry. The Cu defect count was reduced by 66.5% for the glycine/alanine/ethylenediamine based tris chelator + choline bicarbonate Cu slurry when compared to the glycine based single chelator Cu slurry. In other words, Cu defect counts were reduced by 2.2X to 3X in tris chelator or tris chelator plus choline bicarbonate based Cu slurries when compared to the single chelator based Cu slurry.

**Table 3. Cu Defect Count Comparison of Single Chelator vs Tris Chelator Cu Slurries**

| Sample | 0.2µm Cu Defect@.1.5psi (10.2kPa) DF |
|---|---|
| Cu Slurry with single chelator, Glycine | 313 |
| Cu Slurry# 2 with tris chelators, Glycine + DL-Alanine + EDA | 138 |
| Cu Slurry# 2 with tris chelators, Glycine + DL-Alanine + EDA + CBC | 105 |

The use of choline bicarbonate as an additional additive in the tris chelator based Cu slurry not only reduced Cu dishing on some wide Cu line features, but also further reduced Cu defect count by 24% when compared to the tris chelators based Cu slurry.

The tris chelator based Cu CMP slurry or tris chelators with choline salt based Cu slurry showed very high selectivity toward barrier films or dielectric films. For example, greater than 500:1 of Cu: Ta selectivity was obtained for the tris chelator based Cu CMP slurry or tris chelator plus choline salt based Cu slurry.

While the invention has been described in conjunction with specific embodiments thereof, it is evident that many alternatives, modifications, and variations will be apparent to those skilled in the art in light of the foregoing description. Accordingly, departures may be made from such details without departing from the scope of the invention as defined by the following claims.

## Claims

1. A copper chemical mechanical polishing (CMP) composition comprising:
a) 0.0025 wt.% to 25 wt.% abrasive selected from the group consisting of colloidal silica or high purity colloidal silica; colloidal silica particles doped with one or more metal oxides within the lattice of the colloidal silica; colloidal aluminum oxide; colloidal and photoactive titanium dioxide; cerium oxide; colloidal cerium oxide; nano-sized inorganic metal oxide particles; nano-sized diamond particles; nano-sized silicon nitride particles; mono-modal, bi-modal, multi-modal colloidal abrasive particles; organic polymer-based soft abrasive; surface-coated or modified abrasive; composite particles; and combinations thereof;
b) 0.1 wt. % to 18.0 wt. % tris chelators wherein the first tris chelator is an organic amine selected from the group consisting of ethylenediamine, propylenediamine, and butylenediamine; and wherein the second and third chelators are two different amino acids, two different amino acid derivatives, or combinations of one amino acid with one amino acid derivative;
c) 0.005 wt.% to 0.5 wt.% corrosion inhibitor selected from the group consisting of 1,2,4-triazole, benzotriazole and benzotriazole derivatives, tetrazole and tetrazole derivatives, imidazole and imidazole derivatives, benzimidazole and benzimidazole derivatives, pyrazole and pyrazole derivatives, and combinations thereof;
d) 0.0005 wt.% to 0.25 wt.% organic quaternary ammonium salt which is a choline salt formed between choline and other anionic counter ions;
e) 0.1 wt.% to 10 wt.% oxidizing agent;
f) 0.0001 wt.% to 0.05 wt.% biocide;
g) 0 wt.% to 1 wt.% pH adjusting agent; and
h) water;
wherein the composition has a pH in the range of from 3.0 to 12.0;
wherein
the amino acid or the amino acid derivative is selected from the group consisting of glycine, D-alanine, L-alanine, DL-alanine, beta-alanine, valine, leucine, isoleucine, phenylamine, proline, serine, threonine, tyrosine, glutamine, asparanine, glutamic acid, aspartic acid, tryptophan, histidine, arginine, lysine, methionine, cysteine, iminodiacetic acid, and combinations thereof.

2. The copper chemical mechanical polishing (CMP) composition of claim 1, wherein the choline salt has a general molecular structure shown below: 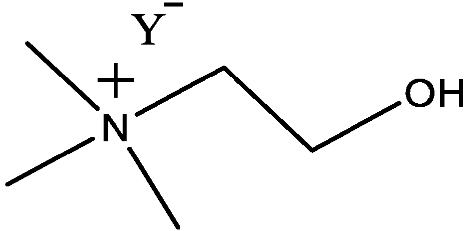
wherein the anion Y⁻ is selected from bicarbonate, hydroxide, p-toluene-sulfonate, or bitartrate, and combinations thereof; and/or
the oxidizing agent is selected from the group consisting of periodic acid, hydrogen peroxide, potassium iodate, potassium permanganate, ammonium persulfate, ammonium molybdate, ferric nitrate, nitric acid, potassium nitrate, and combinations thereof; and/or
the biocide has an active ingredient selected from the group consisting of 5-chloro-2-methyl-4-isothiazolin-3-one, 2-methyl-4-isothiazolin-3-one, and combinations thereof; and/or
the pH adjusting agent is either (1) selected from the group consisting of nitric acid, hydrochloric acid, sulfuric acid, phosphoric acid, and combinations thereof for adjusting the pH toward acidic; or (2) selected from the group consisting of sodium hydride, potassium hydroxide, ammonium hydroxide, tetraalkyl ammonium hydroxide, organic amine, and combinations thereof for adjusting the pH toward alkaline.

3. The copper chemical mechanical polishing (CMP) composition of any preceding claim comprising:
0.0025 wt.% to 2.5 wt.% of colloidal silica or high purity colloidal silica;
0.1 to 18.0 total wt. % of (1) one organic amine selected from the group consisting of ethylenediamine, propylenediamine, and butylenediamine; and (2) two amino acids, two amino acid derivatives, or combinations of one amino acid with one amino acid derivative; wherein the two amino acids are different and the two amino acid derivatives are different;
0.001 wt. % to 0.05 wt. % of choline bicarbonate salt; and
wherein the composition has a pH in the range of from 5.5 to 7.5.

4. The copper chemical mechanical polishing (CMP) composition of claim 3, comprising:
0.0025 wt.% to 2.5 wt.% of colloidal silica or high purity colloidal silica;
0.5 to 10.0 total wt.% of (1) one organic amine selected from the group consisting of ethylenediamine, propylenediamine, and butylenediamine; and (2) two amino acids, two amino acid derivatives, or combinations of one amino acid with one amino acid derivative; wherein the two amino acids are different and the two amino acid derivatives are different;
0.001 wt.% to 0.05 wt.% of choline bicarbonate salt; and
wherein the composition has a pH in the range of from 5.5 to 7.5.

5. The copper chemical mechanical polishing (CMP) composition of claim 3 or claim 4, comprising:
0.0025 wt.% to 2.5 wt.% of colloidal silica or high purity colloidal silica;
0.5 to 1.5 total wt.% of (1) one organic amine selected from ethylenediamine propylenediamine, and butylenediamine; and (2) two different amino acids selected from the group consisting of glycine, D-alanine, L-alanine, DL-alanine, beta-alanine, and other amino acids and their derivatives;
0.001 wt.% to 0.05 wt.% of choline bicarbonate salt; and
wherein the composition has a pH in the range of from 5.5 to 7.5.

6. The copper chemical mechanical polishing (CMP) composition of any one of claims 4 to 5, comprising:
0.0025 wt.% to 2.5 wt.% of colloidal silica or high purity colloidal silica;
1.0 to 2.5 total wt.% of (1) one organic amine selected from ethylenediamine, propylenediamine, and butylenediamine; and (2) two different amino acids selected from the group consisting of glycine, D-alanine, L-alanine, DL-alanine, beta-alanine, and other amino acids and their derivatives;
0.001 wt. % to 0.05 wt. % of choline bicarbonate salt; and
wherein the composition has a pH in the range of from 5.5 to 7.5.

7. The copper chemical mechanical polishing (CMP) composition of any one of claims 1 to 3, comprising:
0.005 wt.% to 0.15 wt.% of colloidal silica or high purity colloidal silica;
0.5 to 1.5 total wt. % of ethylenediamine; glycine and DL-alanine;
0.002 wt. % to 0.01 wt. % of choline bicarbonate salt;
0.5 wt. % to 2.0 wt. % of periodic acid or hydrogen peroxide;
0.025 wt. % to 0.05 wt. % of 1,2,4-triazole or benzotriazole and benzotriazole derivatives;
0.002 wt. % to 0.010 wt. % of the biocide having an active ingredient selected from the group consisting of 5-chloro-2-methyl-4-isothiazolin-3-one, 2-methyl-4-isothiazolin-3-one, and combinations thereof; and
wherein the composition has a pH in the range of from 7.0 to 7.35.

8. A method of chemical mechanical polishing a semiconductor substrate having at least one surface comprising copper (Cu) or a copper-containing material and at least one second material; comprising the steps of:
1) providing the semiconductor substrate;
2) providing a polishing pad;
3) providing a Cu chemical mechanical polishing (CMP) composition as claimed in any of the preceding claims;
4) contacting the at least one surface with the polishing pad and the Cu chemical mechanical polishing composition; and
5) polishing the at least one surface to remove copper or copper-containing material;
wherein at least a portion of the at least one surface comprising copper (Cu) or a copper-containing material and at least one second material is in contact with both the polishing pad and the Cu chemical mechanical polishing composition.

9. The method for chemical mechanical polishing of Claim 8, wherein
the second material is selected from the group consisting of barrier layer selected from the group consisting of Ta, TaN, Ti, and TiN film; dielectric layer selected from the group consisting of TEOS, low-k; and ultra low-k film; and
the removal rate of Cu vs removal rate of the second material is equal or greater than 500:1.

10. A system for chemical mechanical polishing a semiconductor substrate having at least one surface comprising copper (Cu) or copper-containing material and at least one second material; the system comprising:
1) a semiconductor substrate;
2) a polishing pad;
3) a Cu chemical mechanical polishing composition as claimed in any one of claims 1 to 7;
wherein at least a portion of the at least one surface comprising copper (Cu) or copper-containing material and at least one second material is in contact with both the polishing pad and the Cu chemical mechanical polishing composition.

## Patentansprüche

1. Kupferzusammensetzung für chemisch-mechanisches Polieren (CMP), umfassend:
a) 0,0025 Gew.-% bis 25 Gew.-% Abrasivstoff, ausgewählt aus der Gruppe bestehend aus kolloidalem Siliciumdioxid oder hochreinem kolloidalem Siliciumdioxid; kolloidalen Siliciumdioxidpartikeln, die mit einem oder mehreren Metalloxiden innerhalb des Gitters des kolloidalem Siliciumdioxids dotiert sind; kolloidalem Aluminiumoxid; kolloidalem und photoaktivem Titandioxid; Ceroxid; kolloidalem Ceroxid; anorganischen Metalloxidpartikeln in Nanogröße; Diamantpartikeln in Nanogröße; Siliciumnitridpartikeln in Nanogröße; monomodalen, bimodalen, multimodalen kolloidalen Abrasivpartikeln; weichem Abrasivstoff auf organischer Polymerbasis; oberflächenbeschichtetem oder -modifiziertem Abrasivstoff; Verbundpartikeln und Kombinationen davon;
b) 0,1 Gew.-% bis 18,0 Gew.-% Tris-Chelatbildner, wobei der erste Tris-Chelatbildner ein organisches Amin ist, ausgewählt aus der Gruppe bestehend aus Ethylendiamin, Propylendiamin und Butylendiamin; und wobei der zweite und der dritte Chelatbildner zwei unterschiedliche Aminosäuren, zwei unterschiedliche Aminosäurederivate oder Kombinationen einer Aminosäure mit einem Aminosäurederivat sind;
c) 0,005 Gew.-% bis 0,5 Gew.-% Korrosionsschutzmittel, ausgewählt aus der Gruppe bestehend aus 1,2,4-Triazol, Benzotriazol und Benzotriazolderivaten, Tetrazol und Tetrazolderivaten, Imidazol und Imidazolderivaten, Benzimidazol und Benzimidazolderivaten, Pyrazol und Pyrazolderivaten und Kombinationen davon;
d) 0,0005 Gew.-% 0,25 Gew.-% organisches quartäres Ammoniumsalz, das ein Cholinsalz ist, das zwischen Cholin und anderen anionischen Gegenionen gebildet wird;
e) 0,1 Gew.-% bis 10 Gew.-% Oxidationsmittel;
f) 0,0001 Gew.-% bis 0,05 Gew.-% Biozid;
g) 0 Gew.-% bis 1 Gew.-% Mittel zur Einstellung des pH-Werts; und
h) Wasser;
wobei die Zusammensetzung einen pH-Wert im Bereich von 3,0 bis 12,0 aufweist;
wobei
die Aminosäure oder das Aminosäurederivat aus der Gruppe bestehend aus Glycin, D-Alanin, L-Alanin, DL-Alanin, Beta-Alanin, Valin, Leucin, Isoleucin, Phenylamin, Prolin, Serin, Threonin, Tyrosin, Glutamin, Asparagin, Glutaminsäure, Asparaginsäure, Tryptophan, Histidin, Arginin, Lysin, Methionin, Cystein, Iminodiessigsäure und Kombinationen davon ausgewählt ist.

2. Kupferzusammensetzung für chemisch-mechanisches Polieren (CMP) nach Anspruch 1, wobei das Cholinsalz eine im Folgenden gezeigte allgemeine Molekularstruktur aufweist: 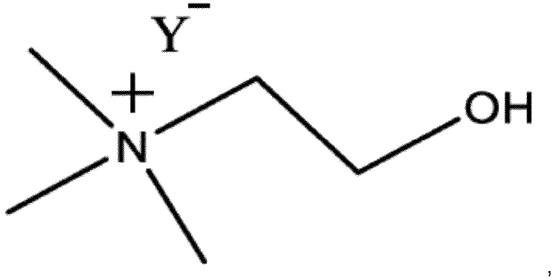
wobei das Anion Y⁻ aus Bicarbonat, Hydroxid, p-Toluolsulfonat oder Bitartrat und Kombinationen davon ausgewählt ist; und/oder
das Oxidationsmittel aus der Gruppe bestehend aus Periodsäure, Wasserstoffperoxid, Kaliumiodat, Kaliumpermanganat, Ammoniumpersulfat, Ammoniummolybdat, Eisen(III)-nitrat, Salpetersäure, Kaliumnitrat und Kombinationen davon ausgewählt ist; und/oder
das Biozid einen Wirkbestandteil aufweist, der aus der Gruppe bestehend aus 5-Chlor-2-methyl-4-isothiazolin-3-on, 2-Methyl-4-isothiazolin-3-on und Kombinationen davon ausgewählt ist; und/oder
das Mittel zur Einstellung des pH-Werts entweder (1) aus der Gruppe bestehend aus Salpetersäure, Salzsäure, Schwefelsäure, Phosphorsäure und Kombinationen davon zur Einstellung des pH-Werts im sauren Bereich ausgewählt ist; oder (2) aus der Gruppe bestehend aus Natriumhydrid, Kaliumhydroxid, Ammoniumhydroxid, Tetraalkylammoniumhydroxid, organischem Amin und Kombinationen davon zur Einstellung des pH-Werts im basischen Bereich ausgewählt ist.

3. Kupferzusammensetzung für chemisch-mechanisches Polieren (CMP) nach einem vorhergehenden Anspruch, umfassend:
0,0025 Gew.-% bis 2,5 Gew.-% kolloidales Siliciumdioxid oder hochreines kolloidales Siliciumdioxid;
0,1 bis 18,0 Gesamtgew.-% (1) eines organischen Amins, ausgewählt aus der Gruppe bestehend aus Ethylendiamin, Propylendiamin und Butylendiamin; und (2) zwei Aminosäuren, zwei Aminosäurederivate oder Kombinationen einer Aminosäure mit einem Aminosäurederivat; wobei die zwei Aminosäuren unterschiedlich sind und die zwei Aminosäurederivate unterschiedlich sind;
0,001 Gew.-% bis 0,05 Gew.-% Cholin-Bicarbonatsalz; und
wobei die Zusammensetzung einen pH-Wert im Bereich von 5,5 bis 7,5 aufweist.

4. Kupferzusammensetzung für chemisch-mechanisches Polieren (CMP) nach Anspruch 3, umfassend:
0,0025 Gew.-% bis 2,5 Gew.-% kolloidales Siliciumdioxid oder hochreines kolloidales Siliciumdioxid;
0,5 bis 10,0 Gesamtgew.-% (1) eines organischen Amins, ausgewählt aus der Gruppe bestehend aus Ethylendiamin, Propylendiamin und Butylendiamin; und (2) zwei Aminosäuren, zwei Aminosäurederivate oder Kombinationen einer Aminosäure mit einem Aminosäurederivat; wobei die zwei Aminosäuren unterschiedlich sind und die zwei Aminosäurederivate unterschiedlich sind;
0,001 Gew.-% bis 0,05 Gew.-% Cholin-Bicarbonatsalz; und
wobei die Zusammensetzung einen pH-Wert im Bereich von 5,5 bis 7,5 aufweist.

5. Kupferzusammensetzung für chemisch-mechanisches Polieren (CMP) nach Anspruch 3 oder Anspruch 4, umfassend:
0,0025 Gew.-% bis 2,5 Gew.-% kolloidales Siliciumdioxid oder hochreines kolloidales Siliciumdioxid;
0,5 bis 1,5 Gesamtgew.-% (1) eines organischen Amins, ausgewählt aus Ethylendiamin, Propylendiamin und Butylendiamin; und (2) zwei unterschiedliche Aminosäuren, ausgewählt aus der Gruppe bestehend aus Glycin, D-Alanin, L-Alanin, DL-Alanin, Beta-Alanin und anderen Aminosäuren und deren Derivaten;
0,001 Gew.-% bis 0,05 Gew.-% Cholin-Bicarbonatsalz; und
wobei die Zusammensetzung einen pH-Wert im Bereich von 5,5 bis 7,5 aufweist.

6. Kupferzusammensetzung für chemisch-mechanisches Polieren (CMP) nach einem der Ansprüche 4 bis 5, umfassend:
0,0025 Gew.-% bis 2,5 Gew.-% kolloidales Siliciumdioxid oder hochreines kolloidales Siliciumdioxid;
1,0 bis 2,5 Gesamtgew.-% (1) eines organischen Amins, ausgewählt aus Ethylendiamin, Propylendiamin und Butylendiamin; und (2) zwei unterschiedliche Aminosäuren, ausgewählt aus der Gruppe bestehend aus Glycin, D-Alanin, L-Alanin, DL-Alanin, Beta-Alanin und anderen Aminosäuren und deren Derivaten;
0,01 Gew.-% bis 0,05 Gew.-% Cholin-Bicarbonatsalz; und
wobei die Zusammensetzung einen pH-Wert im Bereich von 5,5 bis 7,5 aufweist.

7. Kupferzusammensetzung für chemisch-mechanisches Polieren (CMP) nach einem der Ansprüche 1 bis 3, umfassend:
0,005 Gew.-% bis 0,15 Gew.-% kolloidales Siliciumdioxid oder hochreines kolloidales Siliciumdioxid;
0,5 bis 1,5 Gesamtgew.-% Ethylendiamin; Glycin und DL-Alanin;
0,02 Gew.-% bis 0,01 Gew.-% Cholin-Bicarbonatsalz;
0,5 Gew.-% bis 2,0 Gew.-% Periodsäure oder Wasserstoffperoxid;
0,025 Gew.-% bis 0,05 Gew.-% 1,2,4-Triazol oder Benzotriazol und Benzotriazolderivate;
0,002 Gew.-% bis 0,010 Gew.-% des Biozids, das einen Wirkbestandteil aufweist, der aus der Gruppe bestehend aus 5-Chlor-2-methyl-4-isothiazolin-3-on, 2-Methyl-4-isothiazolin-3-on und Kombinationen davon ausgewählt ist; und
wobei die Zusammensetzung einen pH-Wert im Bereich von 7,0 bis 7,35 aufweist.

8. Verfahren zum chemisch-mechanischen Polieren eines Halbleitersubstrats, das mindestens eine Oberfläche aufweist, die Kupfer (Cu) oder ein kupferhaltiges Material und mindestens ein zweites Material umfasst; umfassend die Schritte:
1) Bereitstellen des Halbleitersubstrats;
2) Bereitstellen einer Polierscheibe;
3) Bereitstellen einer Cu-Zusammensetzung für chemisch-mechanisches Polieren (CMP) nach einem der vorhergehenden Ansprüche;
4) Inkontaktbringen der mindestens einen Oberfläche mit der Polierscheibe und der Cu-Zusammensetzung für chemisch-mechanisches Polieren; und
5) Polieren der mindestens einen Oberfläche, um Kupfer oder kupferhaltiges Material zu entfernen;
wobei mindestens ein Teil der mindestens einen Oberfläche, die Kupfer (Cu) oder ein kupferhaltiges Material und mindestens ein zweites Material umfasst, in Kontakt mit sowohl der Polierscheibe als auch der Cu-Zusammensetzung für chemisch-mechanisches Polieren ist.

9. Verfahren zum chemisch-mechanischen Polieren nach Anspruch 8, wobei
das zweite Material aus der Gruppe bestehend aus einer Sperrschicht, ausgewählt aus der Gruppe bestehend aus Ta-, TaN-, Ti- und TiN-Film; einer dielektrischen Schicht, ausgewählt aus der Gruppe bestehend aus TEOS-, Low-k- und Ultra-Low-k-Film, ausgewählt ist; und
die Entfernungsrate von Cu verglichen mit der Entfernungsrate des zweiten Materials gleich oder größer als 500:1 ist.

10. System zum chemisch-mechanischen Polieren eines Halbleitersubstrats, das mindestens eine Oberfläche aufweist, die Kupfer (Cu) oder kupferhaltiges Material und mindestens ein zweites Material umfasst; wobei das System umfasst:
1) ein Halbleitersubstrat;
2) eine Polierscheibe;
3) eine Cu-Zusammensetzung für chemisch-mechanisches Polieren nach einem der Ansprüche 1 bis 7;
wobei mindestens ein Teil der mindestens einen Oberfläche, die Kupfer (Cu) oder kupferhaltiges Material und mindestens ein zweites Material umfasst, in Kontakt mit sowohl der Polierscheibe als auch der Cu-Zusammensetzung für chemisch-mechanisches Polieren ist.

## Revendications

1. Composition de polissage mécanique et chimique (CMP) du cuivre comprenant :
a) de 0,0025 % en poids à 25 % en poids d'abrasif choisi dans le groupe constitué par une silice colloïdale ou une silice colloïdale de grande pureté ; des particules de silice colloïdale dopées par un ou plusieurs oxydes métalliques dans le réseau de la silice colloïdale ; de l'oxyde d'aluminium colloïdal ; du dioxyde de titane colloïdal et photoactif ; de l'oxyde de cérium ; de l'oxyde de cérium colloïdal ; des particules d'oxyde métallique inorganiques de taille nanométrique ; des particules de diamant de taille nanométrique ; des particules de nitrure de silicium de taille nanométrique ; des particules abrasives colloïdales monomodales, bimodales et multimodales ; un abrasif doux à base de polymère organique ; un abrasif à surface enduite ou modifiée ; des particules composites ; et leurs combinaisons ;
b) de 0,1 % en poids à 18,0 % en poids de chélateurs tris, le premier chélateur tris étant une amine organique choisie dans le groupe constitué par l'éthylènediamine, la propylènediamine et la butylènediamine ; et les deuxième et troisième chélateurs étant deux acides aminés différents, deux dérivés d'acides aminés différents, ou des combinaisons d'un acide aminé et d'un dérivé d'acide aminé ;
c) de 0,005 % en poids à 0,5 % en poids d'un inhibiteur de corrosion choisi dans le groupe constitué par le 1-,2,4-triazole, le benzotriazole et des dérivés de benzotriazole, le tétrazole et des dérivés de tétrazole, l'imidazole et des dérivés d'imidazole, le benzimidazole et des dérivés de benzimidazole, le pyrazole et des dérivés de pyrazole, et leurs combinaisons ;
d) de 0,0005 % en poids à 0,25 % en poids de sel d'ammonium quaternaire organique qui est un sel de choline formé entre la choline et d'autres contre-ions anioniques ;
e) de 0,1 % en poids à 10 % en poids d'agent oxydant ;
f) de 0,0001 % en poids à 0,05 % en poids de biocide ;
g) de 0 % en poids à 1 % en poids d'un agent d'ajustement de pH ; et
h) de l'eau ;
la composition ayant un pH compris entre 3,0 et 12.0 ;
**caractérisée en ce que**
l'acide aminé ou le dérivé d'acide aminé est choisi dans le groupe constitué par la glycine, la D-alanine, la L-alanine, la DL-alanine, la bêta-alanine, la valine, la leucine, l'isoleucine, la phénylamine, la proline, la sérine, la thréonine, la tyrosine, la glutamine, l'asparanine, l'acide glutamique, l'acide aspartique, le tryptophane, l'histidine, l'arginine, la lysine, la méthionine, la cystéine, l'acide iminodiacétique et leurs combinaisons.

2. Composition de polissage mécanique et chimique (CMP) du cuivre selon la revendication 1, **caractérisée en ce que** le sel de choline a une structure moléculaire générale illustrée ci-dessous : 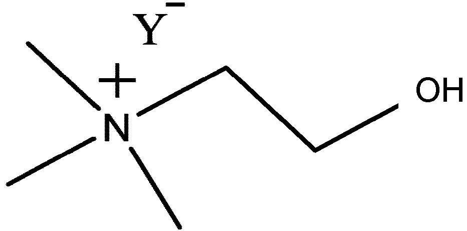
**caractérisée en ce que** l'anion Y- est choisi parmi le bicarbonate, l'hydroxyde, le p-toluène-sulfonate ou le bitartrate, et leurs combinaisons ; et/ou
l'agent oxydant est choisi dans le groupe constitué par l'acide périodique, le peroxyde d'hydrogène, l'iodate de potassium, le permanganate de potassium, le persulfate d'ammonium, le molybdate d'ammonium, le nitrate ferrique, l'acide nitrique, le nitrate de potassium et leurs combinaisons ; et/ou
le biocide contient un principe actif choisi dans le groupe constitué par la 5-chloro-2-méthyl-4isothiazoline-3-one, la 2-méthyl-4-isothiazoline-3-one, et leurs combinaisons ; et/ou
l'agent d'ajustement de pH est soit (1) choisi dans le groupe constitué par l'acide nitrique, l'acide chlorhydrique, l'acide sulfurique, l'acide phosphorique et leurs combinaisons pour rendre le pH plus acide ; ou (2) choisi dans le groupe constitué par l'hydrure de sodium, l'hydroxyde de potassium, l'hydroxyde d'ammonium, l'hydroxyde de tétraalkyleammonium, l'amine organique et leurs combinaisons pour rendre le pH plus alcalin.

3. Composition de polissage mécanique et chimique (CMP) du cuivre selon l'une quelconque des revendications précédentes comprenant :
de 0,0025 % en poids à 2,5 % en poids de silice colloïdale ou de silice colloïdale de grande pureté ;
de 0,1 à 18,0 % en poids total (1) d'une amine organique choisie dans le groupe constitué par l'éthylènediamine, la propylènediamine et la butylènediamine ; et (2) de deux acides aminés, de deux dérivés d'acides aminés, ou des combinaisons d'un acide aminé et d'un dérivé d'acide aminé ; les deux acides aminés étant différents et les deux dérivés d'acides aminés étant différents ;
de 0,001 % en poids à 0,05 % en poids de sel de bicarbonate de choline ; et
**caractérisée en ce que** la composition a un pH compris entre 5,5 et 7,5.

4. Composition de polissage mécanique et chimique (CMP) du cuivre selon la revendication 3, comprenant :
de 0,0025 % en poids à 2,5 % en poids de silice colloïdale ou de silice colloïdale de grande pureté ;
de 0,5 à 10,0 % en poids total (1) d'une amine organique choisie dans le groupe constitué par l'éthylènediamine, la propylènediamine et la butylènediamine ; et (2) de deux acides aminés, de deux dérivés d'acides aminés, ou des combinaisons d'un acide aminé et d'un dérivé d'acide aminé ; les deux acides aminés étant différents et les deux dérivés d'acides aminés étant différents ;
de 0,001 % en poids à 0,05 % en poids de sel de bicarbonate de choline ; et
**caractérisée en ce que** la composition a un pH compris entre 5,5 et 7,5.

5. Composition de polissage mécanique et chimique (CMP) du cuivre selon la revendication 3 ou la revendication 4, comprenant :
de 0,0025 % en poids à 2,5 % en poids de silice colloïdale ou de silice colloïdale de grande pureté ;
de 0,5 à 1,5 % en poids total (1) d'une amine organique choisie parmi l'éthylènediamine, la propylènediamine et la butylènediamine ; et (2) de deux acides aminés différents choisis dans le groupe constitué par la glycine, la D-alanine, la L-alanine, la DL-alanine, la bêta-alanine, et
d'autres acides aminés et leurs dérivés ;
de 0,001 % en poids à 0,05 % en poids de sel de bicarbonate de choline ; et
**caractérisée en ce que** la composition a un pH compris entre 5,5 et 7,5.

6. Composition de polissage mécanique et chimique (CMP) du cuivre selon l'une quelconque des revendications 4 à 5, comprenant :
de 0,0025 % en poids à 2,5 % en poids de silice colloïdale ou de silice colloïdale de grande pureté ;
de 1,0 à 2,5 % en poids total (1) d'une amine organique choisie parmi l'éthylènediamine, la propylènediamine et la butylènediamine ; et (2) de deux acides aminés différents choisis dans le groupe constitué par la glycine, la D-alanine, la L-alanine, la DL-alanine, la bêta-alanine, et d'autres acides aminés et leurs dérivés ;
de 0,001 % en poids à 0,05 % en poids de sel de bicarbonate de choline ; et
**caractérisée en ce que** la composition a un pH compris entre 5,5 et 7,5.

7. Composition de polissage mécanique et chimique (CMP) du cuivre selon l'une quelconque des revendications 1 à 3, comprenant :
de 0,005 % en poids à 0,15 % en poids de silice colloïdale ou de silice colloïdale de grande pureté ;
de 0,5 à 1,5 % en poids total d'éthylènediamine ; de glycine et de DL-alanine ;
de 0,002 % en poids à 0,01 % en poids de sel de bicarbonate de choline ;
de 0,5 % en poids à 2,0 % en poids d'acide périodique ou de peroxyde d'hydrogène ;
de 0,025 % en poids à 0,05 % en poids de 1,2,4-triazole ou de benzotriazole et de dérivés de benzotriazole ;
de 0,002 % en poids à 0,010 % en poids de biocide ayant un principe actif choisi dans le groupe constitué par la 5-chloro-2-méthyl-4-isothiazoline-3-one, la 2-méthyl-4-isothiazoline-3-one, et leurs combinaisons ; et
**caractérisée en ce que** la composition a un pH compris entre 7,0 et 7,35.

8. Procédé de polissage mécanique et chimique d'un substrat semi-conducteur ayant au moins une surface comprenant du cuivre (Cu) ou un matériau contenant du cuivre et au moins un second matériau ; comprenant les étapes suivantes :
1) fourniture du substrat semi-conducteur ;
2) fourniture d'un tampon de planarisation ;
3) fourniture d'une composition de polissage mécanique et chimique (CMP) du cuivre selon l'une quelconque des revendications précédentes ;
4) mise en contact de la ou des surfaces avec le tampon de polissage et la composition de polissage mécanique et chimique de Cu ; et
5) polissage de la ou des surfaces pour éliminer le cuivre ou les matériaux contenant du cuivre ; **caractérisé en ce que** au moins une partie de la surface comprenant du cuivre (Cu) ou un matériau contenant du cuivre et au moins un second matériau est en contact avec le tampon de polissage et la composition de polissage mécanique et chimique de Cu.

9. Procédé de polissage mécanique et chimique selon la revendication 8, **caractérisé en ce que** le second matériau est choisi dans le groupe constitué par une couche barrière choisie dans le groupe constitué par un film de Ta, TaN, Ti et TiN ; une couche diélectrique choisie dans le groupe constitué par un film de TEOS, low-k ; et ultra low-k ; et
le taux d'élimination du Cu par rapport au taux d'élimination du deuxième matériau est égal ou supérieur à 500 : 1.

10. Procédé de polissage mécanique et chimique d'un substrat semi-conducteur ayant au moins une surface comprenant du cuivre (Cu) ou un matériau contenant du cuivre et au moins un second matériau ; le système comprenant :
1) un substrat semi-conducteur ;
2) un tampon de polissage ;
3) une composition de polissage mécanique et chimique du Cu selon l'une quelconque des revendications 1 à 7 ;
**caractérisé en ce qu'**au moins une partie de la surface comprenant du cuivre (Cu) ou du matériau contenant du cuivre et au moins un second matériau est en contact avec le tampon de polissage et la composition de polissage mécanique et chimique du Cu.
